# EUROPEAN PATENT APPLICATION

(11) **EP 3 910 664 A1**
(43) Date of publication of application: **17.11.2021**
(21) Application number: 21164241.8
(22) Date of filing: 23.03.2021
(51) Int. Cl.: H01L 21/20

(54) **CONDUCTIVE STRUCTURE AND METHOD OF CONTROLLING WORK FUNCTION OF METAL**

(30) Priority: 15.05.2020 KR 20200058364
(71) Applicant: Samsung Electronics Co., Ltd., Gyeonggi-do 16677 (KR)
(72) Inventor: SHIN, Hyeonjin, 16678, Gyeonggi-do, (KR); KIM, Sangwon, 16678, Gyeonggi-do, (KR); BYUN, Kyung-Eun, 16678, Gyeonggi-do, (KR); LEE, Eunkyu, 16678, Gyeonggi-do, (KR); KIM, Changhyun, 16678, Gyeonggi-do, (KR); LEE, Changseok, 16678, Gyeonggi-do, (KR)
(74) Representative: Elkington and Fife LLP

(57) **Abstract**

Provided are a conductive structure and a method of controlling a work function of metal. The conductive structure includes a conductive material layer including metal and a work function control layer for controlling a work function of the conductive structure by being bonded to the conductive material layer. The work function control layer includes a two-dimensional material with a defect.

## Description

### FIELD OF THE INVENTION

The disclosure relates to a conductive structure and/or a method of controlling a work function of metal.

### BACKGROUND OF THE INVENTION

Graphene is a material that has a hexagonal honeycomb structure, in which carbon atoms are two-dimensionally connected to each other, and has a very thin thickness at the atomic level. Graphene has high electrical mobility and excellent thermal properties, compared with silicon (Si), and also has advantages of chemical stability and a large surface area.

### SUMMARY OF THE INVENTION

Provided is a conductive structure and/or a method of controlling a work function of metal.

Additional aspects will be set forth in part in the description which follows and, in part, will be apparent from the description, or may be learned by practice of the presented embodiments of the disclosure.

According to an aspect of an embodiment, a conductive structure includes
a conductive material layer including metal and a work function control layer bonded to the conductive material layer. The work function control layer includes a two-dimensional material with a defect, and the work function control layer is configured to control a work function of the conductive structure by being bonded to the conductive material layer.

Investigations have shown that work function is lowered when CVD-grown graphene having a grain size of a few µm or more is bonded to metal. Embodiments propose a structure comprising a first conductive material, and a two-dimensional layered material with a defect bonded to the conductive material layer.

In some embodiments, the work function control layer may be configured to make the work function of the conductive structure lower than a work function of the conductive material layer.

In some embodiments, the two-dimensional material with the defect may have a two-dimensional crystalline structure and a grain size of 100 nm or less. The two-dimensional material with the defect may have a thickness of several nanometers.

In some embodiments, the two-dimensional material with the defect may include nanocrystalline graphene. Metal carbide may be between the conductive material layer and the work function control layer.

In some embodiments, the two-dimensional material with the defect may include nanocrystalline h-boron nitride (h-BN).

In some embodiments, the two-dimensional material with the defect may include a nanocrystalline transition metal dichalcogenide (TMD) compound or nanocrystalline black phosphorous (BP).

In some embodiments, the two-dimensional material with the defect may have a single layer structure or a multilayer structure.

In some embodiments, the work function control layer may be bonded to the conductive material layer by deposition or transfer.

According to an embodiment, a method of controlling a work function of metal includes controlling the work function by bonding a work function control layer to a conductive layer including metal. The work function control layer includes a two-dimensional material with a defect.

In some embodiments, the work function control layer may be configured to control the work function of the conductive structure including the conductive material layer, and the work function control layer may be configured to make the work function of the conductive structure lower than a work function of the conductive material layer.

In some embodiments, the two-dimensional material with the defect may have a two-dimensional crystalline structure and a grain size of 100 nm or less. The two-dimensional material with the defect may have a thickness of several nanometers.

In some embodiments, the two-dimensional material with the defect may include nanocrystalline graphene.

In some embodiments, the two-dimensional material with the defect may include nanocrystalline h-BN, a nanocrystalline transition metal dichalcogenide compound, or nanocrystalline black phosphorous.

In some embodiments, the two-dimensional material with the defect may have a single layer structure or a multilayer structure.

In some embodiments, the work function control layer may be bonded to the conductive material layer by deposition or transfer.

According to an embodiment, a bonding structure includes: a conductive material layer including metal and a work function control layer including a two-dimensional material with a defect. The conductive material layer and the work function control layer may form the bonding structure. According to a change in a thickness of the work function control layer, a work function of the bonding structure does not change or a change rate of the work function of the bonding structure is within 90%. The work function of the bonding structure may be less than a work function of the conductive material layer.

According to an embodiment, a conductive structure includes a conductive material layer including metal and a work function control layer bonded to the conductive material layer. The work function control layer includes a two-dimensional material having a grain size of 100 nm or less. The work function control layer may be configured to control a work function of the conductive structure by being bonded to the conductive material layer. The two-dimensional material may include nanocrystalline graphene, nanocrystalline h-boron nitride (h-BN), a nanocrystalline transition metal dichalcogenide (TMD) compound, or nanocrystalline black phosphorous (BP).

In some embodiments, the work function control layer including the two-dimensional material may have a single layer structure or a multilayer structure.

In some embodiments, the conductive structure may further include a metal carbide between the conductive material layer and the work function control layer. The work function control layer may include nanocrystalline graphene. The work function control layer may have a thickness of 10 nm or less.

In some embodiments, the work function control layer may include nanocrystalline h-boron nitride (h-BN), a nanocrystalline transition metal dichalcogenide (TMD) compound, or nanocrystalline black phosphorous (BP).

### BRIEF DESCRIPTION OF THE DRAWINGS

The above and other aspects, features, and effects of example embodiments of the disclosure will be more apparent from the following description taken in conjunction with the accompanying drawings, in which:
FIG. 1 illustrates an experimental result showing that a work function may be reduced by bonding crystalline graphene to metal;
FIG. 2 illustrates that a semiconductor layer is provided in a conductive structure in which crystalline graphene is bonded to a metal layer;
FIG. 3 illustrates a change in the height of a Schottky barrier according to the number of crystalline graphene layers in the structure of FIG. 2;
FIGS. 4A to 4G illustrate conductive structures according to example embodiments; and
FIGS. 5A and 5B illustrate D-parameter spectrums with respect to nanocrystalline graphene and an amorphous carbon layer, respectively.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, "at least one of A, B, and C," "at least one of A, B, or C," "one of A, B, C, or a combination thereof," and "one of A, B, C, and a combination thereof," respectively, may be construed as covering any one of the following combinations: A; B; A and B; A and C; B and C; and A, B, and C."

Reference will now be made in detail to embodiments, examples of which are illustrated in the accompanying drawings. Throughout the drawings, like reference numerals refer to like elements. The thickness or size of each layer illustrated in the drawings may be exaggerated for convenience of explanation and clarity. Furthermore, as embodiments described below are non-limiting, various other modifications may be produced from the embodiments.

In a layer structure, when a constituent element is disposed "above" or "on" to another constituent element, the constituent element may be only directly on the other constituent element or above the other constituent elements in a non-contact manner. An expression used in the singular encompasses the expression of the plural, unless it has a clearly different meaning in the context. It will be further understood that the terms "comprises" and/or "comprising" used herein specify the presence of stated features or components, but do not preclude the presence or addition of one or more other features or components.

The use of the terms "a" and "an" and "the" and similar referents in the context of describing the disclosure are to be construed to cover both the singular and the plural. Also, the steps of all methods described herein can be performed in any suitable order unless otherwise indicated herein or otherwise clearly contradicted by context. The disclosure is not limited to the described order of the steps.

Furthermore, terms such as "∼ portion", "∼ unit", "∼ module", and "∼ block" stated in the specification may signify a unit to process at least one function or operation and the unit may be embodied by hardware, software, or a combination of hardware and software.

Furthermore, the connecting lines, or connectors shown in the various figures presented are intended to represent functional relationships and/or physical or logical couplings between the various elements.

The use of any and all examples, or language (e.g., "such as") provided herein, is intended merely to better illuminate the disclosure and does not pose a limitation on the scope of the disclosure unless otherwise claimed.

A two-dimensional material refers to a material having a crystalline structure in which atoms are connected in a two-dimensional form, and has a very thin thickness of an atomic level, for example, about several nanometers (e.g., 10 nm or less, or 25 nm or less). The two-dimensional material may include a single layer or a multilayer structure. When the two-dimensional material has a multilayer structure, layers are relatively weakly connected to each other by van der Waals forces.

The two-dimensional material generally means a two-dimensional crystalline material with no defect, and may have a single crystal structure or a polycrystalline structure. For example, a two-dimensional material with no defect may have a grain size greater than 100 nm.

Graphene is a material that has a crystalline structure in the form of a hexagonal honeycomb, in which carbon atoms are two-dimensionally connected to each other. Graphene may have a single layer or multilayer structure, and single-layer graphene may have a thickness of about 0.34 nm. Graphene, in which carbon atoms are connected to each other with strong covalent bonds on a two-dimensional plane, exhibits high physical chemical stability and excellent mechanical, electrical, and thermal properties.

In general, graphene means crystalline graphene, and crystalline graphene may be referred to as intrinsic graphene. Crystalline graphene may have a grain size greater than, for example, 100 nm. For example, crystalline graphene may have a grain size of several micrometers or more.

Crystalline graphene is known to be able to change a work function by being bonded to metal. In detail, when crystalline graphene is bonded to metal, charge transfer occurs between the metal and the crystalline graphene, forming interface dipoles. Accordingly, the metal to which the crystalline graphene is bonded is known to be able to reduce a work function compared with metal to which no crystalline graphene is bonded.

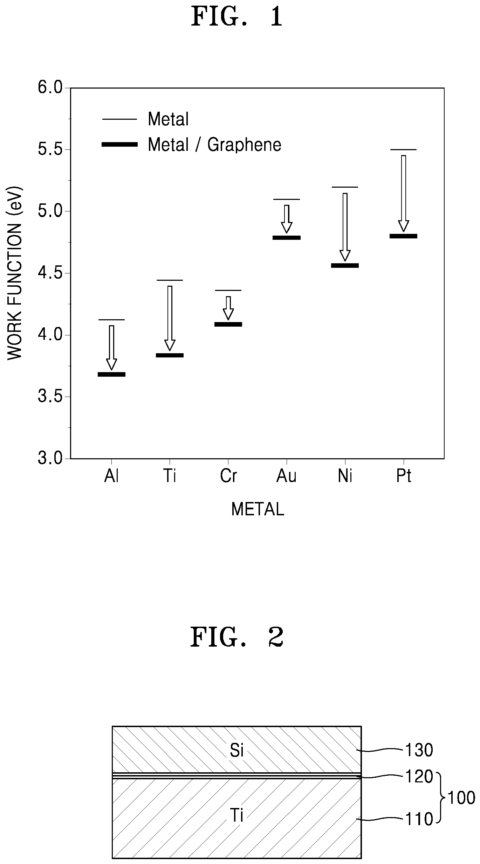

FIG. 1 illustrates an experimental result showing that a work function may be reduced by bonding crystalline graphene to metal. In FIG. 1, an experimental result shows work functions of metals and work functions of conductive structures in which crystalline graphene is bonded to each of the metals.

In FIG. 1, work functions of metals, in detail, Al, Ti, Cr, Au, Ni, and Pt and work functions of conductive structures in which crystalline graphene is bonded to each of the metals are illustrated. The crystalline graphene, as crystalline graphene of a single layer structure, has a thickness of about 0.34 nm. The crystalline graphene is bonded to metal by physical vapor deposition (PVD). Crystalline graphene of a single layer structure may have a work function of about 4.5 eV.

Referring to FIG. 1, it can be seen that a work function of a conductive structure in which crystalline graphene is bonded to metal is lower than that of the metal. For example, while a work function of Ti is about 4.45 eV, a work function of Ti to which crystalline graphene of a single layer structure is bonded is reduced to about 3.84 eV. Accordingly, it can be seen that a work function may be reduced by bonding crystalline graphene to metal.

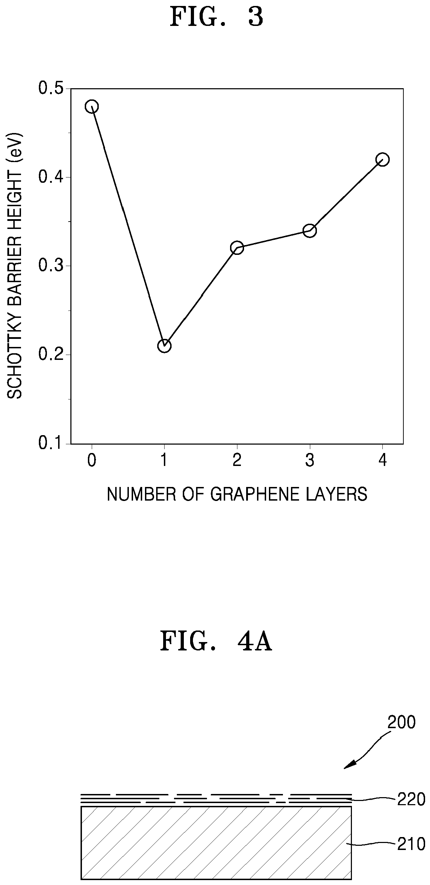

FIGS. 2 and 3 illustrate an experimental result showing that a work function reduction effect decreases when a metal layer is provided with a plurality of crystalline graphene layers.

FIG. 2 illustrates that a semiconductor layer 130 is provided on a conductive structure 100 in which a crystalline graphene 120 is bonded to a metal layer 110.

Referring to FIG. 2, the crystalline graphene 120 is bonded to a surface of the metal layer 110, and the semiconductor layer 130 is provided thereon. A Ti layer is used as the metal layer 110, and a Si layer is used as the semiconductor layer 130, but example embodiments are not limited thereto and, in some embodiments, the metal layer 110 may include a different metal than Ti or a metal alloy. Also, the semiconductor layer 130 may include a different semiconductor than Si in some embodiments.

FIG. 3 illustrates an experimental result showing a change in the height of a Schottky barrier according to the number of layers of the crystalline graphene 120 in the structure of FIG. 2.

Referring to FIG. 3, it can be seen that the height of a Schottky barrier formed between the conductive structure 100 and the semiconductor layer 130 when the crystalline graphene 120 is provided as a single layer is much lower than the height of a Schottky barrier formed between the metal layer 110 and the semiconductor layer 130 when the crystalline graphene 120 is not provided. This means that a work function may be much reduced when the crystalline graphene 120 of a single layer structure is bonded to the metal layer 110.

However, it can be seen that, when the crystalline graphene 120 is provided as two layers, three layers, or four layers, the height of a Schottky barrier formed between the conductive structure 100 and the semiconductor layer 130 is not much reduced compared with a case in which crystalline graphene is not provided. This means that a work function may not be effectively reduced when the crystalline graphene 120 of a multilayer structure is bonded to the metal layer 110.

FIGS. 4A to 4G illustrate conductive structures according to example embodiments.

Referring to FIG. 4A, a conductive structure 200 may include a conductive material layer 210 and a work function control layer 220 bonded to a surface of the conductive material layer 210. The conductive structure 200 may be a bonding structure of the conductive material layer 210 and the work function control layer 220. The conductive material layer 210 may include metal. For example, the conductive material layer 210 may include Ti, W, Ai, Cr, Au, Ni, Pt, Mo, W, Ru, Rh, Ir, Cu, etc. However, this is merely an example, and the conductive material layer 210 may include various other materials.

The work function control layer 220 is bonded to the conductive material layer 210 and may control a work function. In detail, the work function control layer 220 is bonded to the conductive material layer 210, forming the conductive structure 200, and may reduce the work function of the conductive structure 200 to be lower than the work function of the conductive material layer 210.

Furthermore, according to a change in the thickness of the work function control layer 220, the work function of the conductive structure 200 may not be changed, or a change rate of the work function of the conductive structure 200 may be within 90%.

In the present embodiment, the work function control layer 220 may include a two-dimensional material with a defect. The term "two-dimensional material with a defect" may mean a two-dimensional material having a relatively small grain size compared with a two-dimensional material with no defect. In detail, while the two-dimensional material with no defect has a grain size greater than 100 nm as described above, the two-dimensional material with a defect may have a grain size of 100 nm or less. For example, the two-dimensional material with a defect may have a grain size of about 1 nm to about 100 nm.

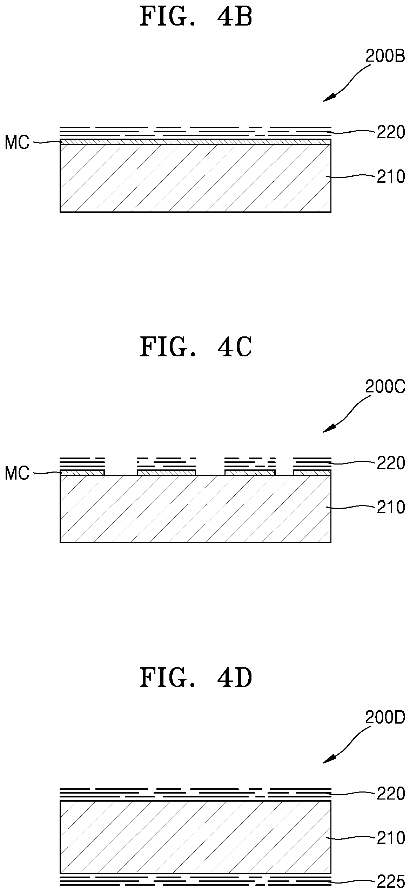

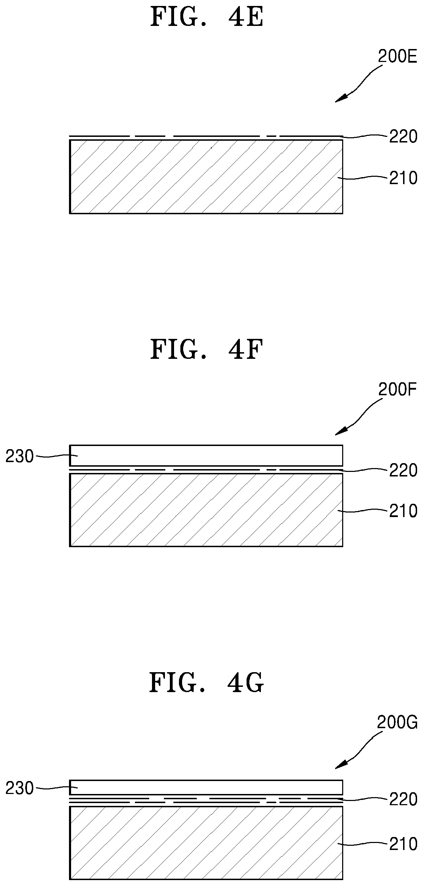

The two-dimensional material with a defect constituting the work function control layer 220 may have a single layer structure (as depicted in FIGS. 4E and 4F) or a multilayer structure (as depicted in FIGS. 4A to 4D and 4G for example) in any of the embodiments illustrated in FIGS. 4A to 4G. The work function control layer 225 in FIG. 4D also may be a single layer structure or a multilayer structure. The two-dimensional material with a defect may have a thickness of about several nanometers. For example, the two-dimensional material with a defect may have a thickness of about 10 nm or less, but the disclosure is not limited thereto.

In some embodiments, as depicted in FIGS. 4F and 4G, a semiconductor layer 230 (e.g., silicon) may be formed on the work function control layer 220.

The work function control layer 220 may be formed by bonding the two-dimensional material with a defect to the conductive material layer 210 by a method, for example, chemical vapor deposition (CVD), PVD, or transfer.

In the present embodiment, when the work function control layer 220 including the two-dimensional material with a defect is bonded to the conductive material layer 210 including metal, a work function may be reduced. Furthermore, as described above, while the crystalline graphene having a signal layer structure only may effectively reduce a work function, the two-dimensional material with a defect constituting the work function control layer 220 in the present embodiment may effectively reduce a work function even when the two-dimensional material with a defect has a single layer structure or a multilayer structure.

The two-dimensional material with a defect constituting the work function control layer 220 may include nanocrystalline graphene, nanocrystalline h-boron nitride (h-BN), nanocrystalline transition metal dichalcogenide (TMD), or nanocrystalline black phosphorous (BP). The term "nanocrystalline" may mean that a two-dimensional material has a grain size of 100 nm or less.

The nanocrystalline graphene may mean graphene having a nano-level grain size. In detail, the nanocrystalline graphene may have a grain size of 100 nm or less. For example, nanocrystalline graphene may have a grain size of about 1 nm to about 100 nm. The nanocrystalline graphene may have a single layer or multilayer structure. A nanocrystalline graphene of a single layer structure may have a thickness of about 0.34 nm. A nanocrystalline graphene of a multilayer structure may have a thickness of several nanometers, for example, about 10 nm or less.

In the following description, the crystalline graphene, the nanocrystalline graphene, and an amorphous carbon layer are described in detail in comparison with one another.

A ratio of carbon having an sp² bonding structure to the entire carbon may be obtained by the measurement of a D-parameter through an X-ray photoelectron spectroscopy (XPS) analysis. In detail, in the XPS analysis, a peak shape of the Auger spectrum of carbon varies according to the ratio of carbon having an sp² bonding structure to the entire carbon. In the D-parameter spectrum formed by differentiating the peak shape, an interval between the highest point and the lowest point is a D-parameter. Accordingly, the crystalline graphene, the nanocrystalline graphene, and the amorphous carbon layer may be distinguished by measuring the D-parameter in the Auger spectrum of carbon. Furthermore, a hydrogen content may be obtained through an ingredient analysis of, for example, Rutherford backscattering spectroscopy (RBS).

For crystalline graphene, the D-parameter in the Auger spectrum of carbon may be about 23 eV. In this case, the ratio of carbon having an sp² bonding structure to the entire carbon may be almost 100%. Such a general crystalline graphene may hardly include hydrogen. The general crystalline graphene may have a density of, for example, about 2.1 g/cc, and sheet resistance may be, for example, about 100∼300 Ohm/sq.

The nanocrystalline graphene may include crystals having a size less than those of the general crystalline graphene. In a detailed example, the nanocrystalline graphene may include crystals having a size of about 0.5 nm to about 100 nm. In the nanocrystalline graphene, the D-parameter in the Auger spectrum of carbon may be about 18 eV to about 22.9 eV. In this case, the ratio of carbon having an sp² bonding structure to the entire carbon may be, for example, about 50% to about 99%. The nanocrystalline graphene may include hydrogen of, for example, about 1 at% to about 20 at% (atomic percent). Furthermore, the nanocrystalline graphene may have a density of, for example, about 1.6 g/cc to about 2.1 g/cc, and the sheet resistance thereof may be greater than, for example, about 1000 Ohm/sq.

In the amorphous carbon layer, the D-parameter in the Auger spectrum of carbon may have a value between a D-parameter of diamond, that is, about 13 eV, and the D-parameter of the nanocrystalline graphene. In this case, the ratio of carbon having an sp² bonding structure to the entire carbon may be, for example, about 30% to about 50%. The amorphous carbon layer may include a hydrogen content greater than, for example, about 20 at%.

In the following description, as an example method of forming the above-described nanocrystalline graphene, a method of directly growing and forming nanocrystalline graphene on a surface of a substrate by using a plasma enhanced CVD (PECVD) process.

After injecting a reactive gas for the growth of nanocrystalline graphene into a reaction chamber provided with a substrate, power for generation of plasma is applied thereto.

In detail, first, a substrate for growing nanocrystalline graphene is prepared in the reaction chamber. A substrate of various materials may be used as the substrate used for the growth of nanocrystalline graphene.

The substrate may include, for example, at least one of a Group IV semiconductor material, a semiconductor compound, metal, or an insulating material. As a detailed example, the Group IV semiconductor material may include Si, Ge, or Sn. The semiconductor compound may include, for example, a material obtained by combining at least two elements of Si, Ge, C, Zn, Cd, Al, Ga, In, B, C, N, P, S, Se, As, Sb, or Te. The metal may include, for example, at least one of Cu, Mo, Ni, Al, W, Ru, Co, Mn, Ti, Ta, Au, Hf, Zr, Zn, Y, Cr, or Gd. The substrate may further include a dopant. The above-described materials of the substrate are merely non-limiting examples, and the substrate may include various other materials.

Next, a reactive gas for the growth of nanocrystalline graphene is injected into the reaction chamber. The reactive gas may include a carbon source, an inert gas, and a hydrogen gas. Alternatively, the reactive gas may not include a hydrogen gas.

A carbon source may be a source for supplying carbon for the growth of nanocrystalline graphene. For example, the carbon source may include at least one of a hydrocarbon gas or vapor of a liquid precursor including carbon.

The hydrocarbon gas may include, for example, a methane gas, an ethylene gas, an acetylene gas, or a propylene gas, but this is merely an example, and gases of various other materials may be included.

The liquid precursor may include at least one of aromatic hydrocarbon having a chemical formula of CₓH_{y} (6≤x≤42 and 6≤y≤28) and derivatives thereof and aliphatic hydrocarbon having a chemical formula of CₓH_{y} (1≤x≤12, and 2≤y≤26) and derivatives thereof. The aromatic hydrocarbon may include, for example, benzene, toluene, xylene, or anisol, and the aliphatic hydrocarbon may include, for example, hexane, octane, isopropyl alcohol, or ethanol. However, this is merely an example.

The inert gas may include, for example, at least one of an argon gas, a neon gas, a nitrogen gas, a helium gas, a krypton gas, or a xenon gas.

Next, a plasma power source applies power for generating plasma to the inside of the reaction chamber. The power for generating plasma may be about 10 W to about 4000 W. However, the disclosure is not limited thereto.

For example, a radio frequency (RF) plasma generator or a microwave (MW) plasma generator may be used as the plasma power source. In order to grow nanocrystalline graphene, the RF plasma generator may generate RF plasma having a frequency range of, for example, about 3 MHz to about 100 MHz, and the MW plasma generator may generate MW plasma having a frequency range of, for example, about 0.7 GHz to about 2.5 GHz. However, the above frequency range is merely an example, and various other frequency ranges may be used. A plurality of RF plasma generators or a plurality of MW plasma generators may be used as the plasma power source.

When the plasma power source applies power for generating plasma to the inside of the reaction chamber, an electric field may be induced in the reaction chamber. As such, when the reactive gas is injected and then an electric field is induced, plasma for the growth of the nanocrystalline graphene 190 is formed.

When plasma is used to grow the nanocrystalline graphene, a mixing ratio of the reactive gas injected into the reaction chamber, that is, a volume ratio of a carbon source, an inert gas, and a hydrogen gas may be, for example, about 1:0.01 to 5000:0 to 300. The volume ratio of a carbon source, an inert gas, and a hydrogen gas included in the reactive gas may be appropriately adjusted depending on other growth conditions.

A process temperature for growing the nanocrystalline graphene may be about 700 °C or less, which is less than the temperature used for a general CVD process. In a detailed example, the process temperature in the reaction chamber may be about 180 °C to about 700 °C. The process pressure for growing the nanocrystalline graphene 190 may be about 0.001 Torr to about 10 Torr. However, this is merely an example, and other process pressures may be used therefor.

Active carbon radicals are generated by the plasma of the reactive gas in which the carbon source, the inert gas, and the hydrogen gas are mixed, and adsorbed on the surface of the substrate. In detail, plasma of the inert gas of the reactive gas generates active carbon radicals from a carbon source gas, and the generated active carbon radicals are adsorbed on the surface of the substrate so that the surface of the substrate is activated. As the plasma of an inert gas continuously induces activation of the substrate, the adsorption of active carbon radicals on the surface of the substrate may be accelerated.

As such, as the adsorption of active carbon radicals on the surface of the substrate is accelerated, the nanocrystalline graphene may grow on the surface of the substrate at a relatively fast speed. For example, the nanocrystalline graphene may grow to a thickness of 0.05 nm or more per minute on the surface of the substrate. However, the disclosure is not limited thereto. Accordingly, the nanocrystalline graphene may grow to a desired thickness within a relatively short time. The nanocrystalline graphene may have a single layer or multilayer structure.

Thereafter, another layer (e.g., semiconductor layer such as a silicon layer or a metal layer) may be deposited on the nanocrystalline graphene.

In another embodiment, a method of forming nanocrystalline boron nitride (BN) is provided. A system for forming a boron nitride layer is described in co-pending U.S. Application No. 17/082,494, entitled "Interconnect Structure and Electronic Apparatus Including the Same" and filed on October 28, 2020, the entire disclosure of which is incorporated by reference herein.

In an embodiment, a boron nitride layer may be grown on a semiconductor substrate (e.g., Si substrate) by an inductively coupled plasma-chemical vapor deposition (ICP-CVD) method at a process pressure of about 10⁻⁴ Torr and a process temperature of about 400 °C (and/or about 700 °C or less).

The substrate may include at least one of a Group IV semiconductor material, a semiconductor compound, an insulating material, and metal. As a specific example, the substrate may include the Group IV semiconductor material such as Si, Ge, or Sn. Alternatively, the substrate may include at least one of Si, Ge, C, Zn, Cd, Al, Ga, In, B, C, N, P, S, Se, As, Sb, Te, Ta, Ru, Rh, Ir, Co, Ta, Ti, W, Pt, Au, Ni, and Fe. In addition, the substrate may further include, for example, N and F as a SiCOH-based composition, and may also include pores to lower the permittivity. In addition, the substrate may further include a dopant. The materials of the substrate mentioned above are merely examples.

The substrate may be pretreated before the substrate is disposed in a process chamber for growing the boron nitride layer. For example, the substrate may be immersed in an organic solvent such as acetone, sonicated, and then cleaned with iso-propenyl alcohol (IPA) and nitrogen gas. A plasma treatment such as oxygen, hydrogen, NH₃, etc. may be performed on the surface of the substrate, which is cleaned, such that carbon impurities remaining on the surface may be removed. In addition, the substrate may be immersed in an HF solution to remove natural oxides or remove a residual HF solution using anhydrous ethanol and N₂ gas.

The process temperature for growing the boron nitride layer may be about 700 °C or less, which is lower than the temperature used for a chemical vapor deposition process. For example, the process temperature of the inside of the chamber may be about 400 °C. Before the process temperature rises, the process pressure for growing the boron nitride layer may be set to about 2 Torr or less. For example, the process pressure may be 10⁻² Torr or less.

Next, a reaction gas for growing the boron nitride layer may be injected into the chamber. Here, the reaction gas may be a source for boron nitride for the growth of the boron nitride layer and may be a source including both nitrogen and boron, such as borazine (B₃N₃H₆) or ammonia-borane (NH₃-BH₃). Alternatively, the reaction gas may include a nitrogen source including nitrogen and a boron source including boron. The nitrogen source may include at least one of ammonia (NH₃) or nitrogen (N₂), and the boron source may include at least one of BH₃, BF₃, BCI3, B₂H₆, (CH₃)₃B, and (CH₃CH₂)₃B.

The reaction gas may further include an inert gas. The inert gas may include, for example, at least one of argon gas, neon gas, nitrogen gas, helium gas, krypton gas, and xenon gas. The reaction gas may further include a hydrogen gas. In addition, the mixing ratio of the reaction gas injected into the chamber may be variously modified according to the growth conditions of the boron nitride layer.

A flow rate controller may control the flow rate of the reaction gas flowing into the chamber. The flow rate of the boron nitride gas may be lower than other reactant gases. When the boron nitride layer is to grown using plasma, the mixing ratio of the reaction gas injected into the chamber, that is, the volume ratio of the source of boron nitride and the inert gas, may be, for example, about 1:10 to 5000, and the volume ratio of the source of boron nitride, the inert gas, and the hydrogen gas, may be, for example, about 1:10 to 5000:10 to 500.

Since the source for boron nitride is significantly smaller in proportion to other reaction gases, the crystallinity of boron nitrides may be weak. Thus, the boron nitride layer may be formed in an amorphous or a nano-sized crystal structure.

When an excess amount of the source for boron nitride is supplied, the boron nitride layer may grow irregularly, and a precursor may be adsorbed, and thus, the flow rate of the source for boron nitride may be low.

For example, while growing the boron nitride layer, the flow rate controller may control the flow rate of the source for boron nitride to 0.05 sccm, the flow rate of the inert gas to 50 sccm, and the flow rate of the hydrogen gas to 20 sccm. The flow rate controller 13 controls the flow rates of the boron nitride source and the inert gas, but is not limited thereto. The flow rate controller may control only the flow rate of the source for boron nitride.

Subsequently, a plasma apparatus may generate plasma inside the chamber while the source for boron nitride is introduced into the chamber. The power for plasma generation may be about 10 W to about 4000 W. For example, the power for plasma generation is about 30 W, but is not limited thereto.

The plasma apparatus may be an apparatus that provides plasma including an inductively coupled plasma, a capacitively coupled plasma, a microwave plasma, a plasma enhanced method, an electron cyclotron resonance plasma, arc discharge plasma, a helicon plasma, etc., but is not limited thereto. For example, an inductively coupled plasma apparatus may provide a kind of plasma in which energy is supplied by a current generated by electromagnetic induction, that is, a magnetic field that changes over time. When the power for generating plasma is applied to the inside of the chamber from the plasma apparatus, an electric field may be induced inside the chamber. As described above, when the electric field is induced in a state where the reaction gas is injected, plasma for the growth of a boron nitride layer may be formed.

Activated nitrogen and activated boron may be generated by the plasma of the reaction gas in which the carbon source, the inert gas, and the hydrogen gas are mixed and may be adsorbed onto the surface of the substrate. In addition, the plasma of the inert gas may continuously induce the activation of the substrate, and thus, the adsorption of the activated nitrogen and the activated boron onto the surface of the substrate may be accelerated. The activated nitrogen and the activated boron may be adsorbed as amorphous. Even if activated nitrides and boron are combined with each other, since an amount thereof is small, activated nitrides and boron may be adsorbed as the nano-sized crystal.

As the adsorption of the activated nitrogen and the activated boron onto the surface of the substrate is accelerated even at a low temperature, the boron nitride layer may grow on the surface of the substrate. According to the present embodiment, since the boron nitride layer directly grows on the surface of the substrate by a low ratio of the activated nitrogen and the activated boron at a low temperature, for example, at a temperature of 700 °C or less, the boron nitride layer, which is grown, may have weak crystalline.

The boron nitride layer according to an embodiment may grow as amorphous or may grow as the nano-sized crystal. Although there is a crystal in the boron nitride layer formed as amorphous, there may be a crystal of 3 nm or less, and the boron nitride layer formed as the nano crystal may include crystals having a size of about 100 nm or less. More specifically, the boron nitride layer may include crystals having a size of about 0.5 nm to about 100 nm.

The thickness of the boron nitride layer according to an embodiment may be grown to about 10 nm or less, but is not limited thereto.

After growth of the boron nitride layer, the plasma may be turned off and a furnace that adjusts the temperature of the chamber may be gradually cooled at the room temperature.

A device may be fabricated by forming another layer on the boron nitride layer. Alternatively, the fabricated boron nitride layer may be transferred to another layer. When transferred, a hydrofluoric acid transfer technique may be applied, but the present disclosure is not limited thereto.

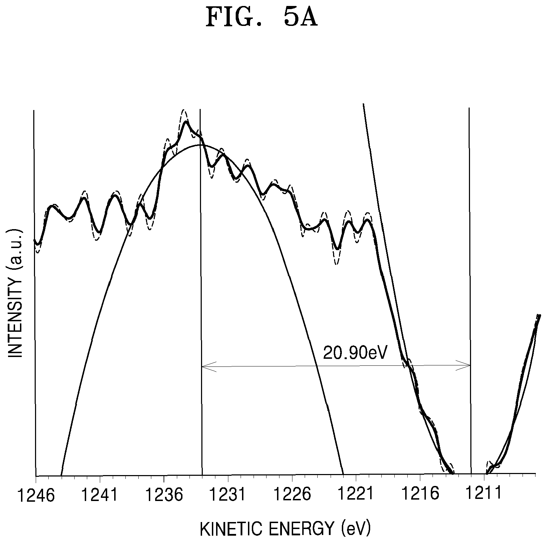

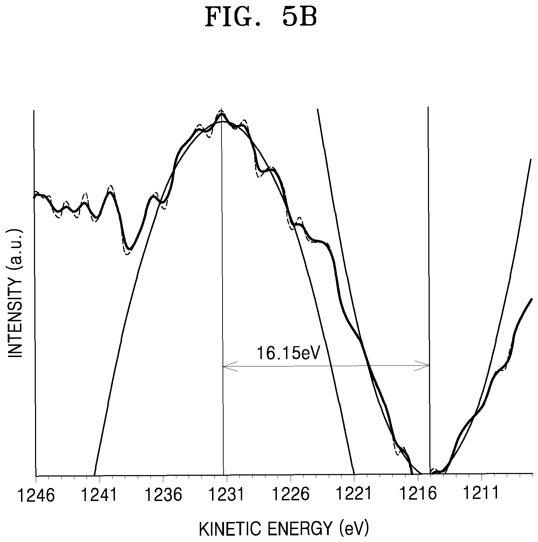

FIGS. 5A and 5B illustrate D-parameter spectrums with respect to the nanocrystalline graphene and the amorphous carbon layer, respectively.

In FIG. 5A, a polysilicon substrate is used as the substrate in a PECVD process, and an RF plasma generator (13.56 MHz) is used as the plasma power source. The RF power for generating plasma is 600 W. A growth temperature of 700 °C, a process pressure of 0.02 Torr, and a growth time of 20 minutes are used as growth conditions. Furthermore, 1 sccm of an acetylene gas, 50 sccm of an argon gas, and 100 sccm of a hydrogen gas are respectively used as the carbon source gas, the inert gas, and the hydrogen gas included in the reactive gas.

A D-parameter spectrum to a material layer formed on the surface of a polysilicon substrate by a plasma CVD process as above is illustrated in FIG. 5A. Referring to FIG. 5A, in the D-parameter spectrum, the D-parameter is measured to be about 20.90 eV, from which it can be seen that the nanocrystalline graphene grows on a surface of the polysilicon substrate. In this state, the measured thickness of the nanocrystalline graphene may be about 2 nm. As such, it can be seen that, when the inert gas is included in the reactive gas, the nanocrystalline graphene is directly grown and formed on the surface of the substrate within a relatively short time.

FIG. 5B illustrates a D-parameter spectrum with respect to the amorphous carbon layer. As the D-parameter is about 16.15 eV in the D-parameter spectrum, it can be seen that the D-parameter with respect to the amorphous carbon layer is different from the D-parameter with respect to the above-described nanocrystalline graphene.

The conductive structure 200 may be manufactured by bonding the work function control layer 220 including the above-described nanocrystalline graphene to the conductive material layer 210 including metal. Metal carbide (as depicted in the conductive structure 200B in FIG. 4B, which includes metal carbide MC) may be further provided between the conductive material layer 210 and the work function control layer 220. However, the disclosure is not limited thereto, and the metal carbide may not be provided.

The work function control layer 220 may be formed by directly growing nanocrystalline graphene on the conductive material layer 210 including metal, by using the above-described CVD, specifically PECVD. However, this is merely an example, and the work function control layer 220 may be formed by depositing nanocrystalline graphene on the conductive material layer 210 including metal, by using PVD. Furthermore, the work function control layer 220 may be formed by transferring nanocrystalline graphene manufactured by using CVD or PVD to the conductive material layer 210 including metal.

A work function may be controlled by bonding the work function control layer 220 including the nanocrystalline graphene to the conductive material layer 210 including metal by deposition or transfer. In detail, when the conductive structure 200 is formed by bonding the work function control layer 220 including the nanocrystalline graphene to the conductive material layer 210 including metal, the work function of the conductive structure 200 may be reduced to be lower than the work function of the metal constituting the conductive material layer 210.

For example, the work function of tungsten (W) is about 4.73 eV. After a conductive structure is manufactured by transferring nanocrystalline graphene having a thickness of several nanometers (about 10 layers) to a surface of a conductive material layer including W, the work function of the conductive structure is measured. The work function of the conductive structure was measured to be about 4.23 eV, and it can be seen that the measurement value is reduced to be much lower than the work function of W.

In another example, a work function of nickel (Ni) is about 4.45 eV. After a conductive structure is manufactured by transferring nanocrystalline graphene having a thickness of several nanometers (about 10 layers) to a surface of a conductive material layer including Ni, the work function of the conductive structure is measured. The work function of the conductive structure was measured to be about 3.99 eV, and it can be seen that the measurement value is reduced to be much lower than the work function of Ni. Accordingly, the work function of the conductive structure may be reduced to be lower than the work function of the metal constituting the conductive material layer by bonding nanocrystalline graphene to the conductive material layer 210 including metal.

Furthermore, as described above, when a plurality of crystalline graphene layers are bonded to the conductive material layer including metal, the work function may not be effectively reduced. However, in the present embodiment, the work function may be effectively reduced even when a plurality of nanocrystalline graphene layers are bonded to the conductive material layer 210 including metal.

In the above description, nanocrystalline graphene is described as an example of the two-dimensional material with a defect which may reduce the work function by being bonded to the conductive material layer including metal. However, there are various other two-dimensional materials with a defect which may control the work function by being bonded to the conductive material layer including metal.

For example, the two-dimensional material with a defect constituting the work function control layer may include nanocrystalline h-BN as an insulating material. Furthermore, the two-dimensional material with a defect constituting the work function control layer may include, as a semiconductor material, nanocrystalline TMD or nanocrystalline BP.

According to the above-described example embodiments, the work function of metal may be controlled by bonding the two-dimensional material with a defect to the conductive material layer including metal. In detail, the work function of the conductive material layer to which the two-dimensional material is bonded may be reduced to be lower than the work function of the metal constituting the conductive material layer. Furthermore, while the crystalline graphene may effectively reduce the work function only with the crystalline graphene that has a single layer structure, in the present embodiment, the work function may be effectively reduced when the two-dimensional material with a defect has not only a single layer structure, but also a multilayer structure. The above-described embodiments are merely examples, and various other modifications thereof may be possible.

For example, referring to FIG. 4C, a conductive structure 200C according to an embodiment may be the same as the conductive structure 200B in FIG. 4B, except the work function control layer 220 and metal carbide MC may be patterned. Optionally, the metal carbide MC may be omitted in the conductive structure 200C.

Referring to FIG. 4D, a conductive structure 200D according to an embodiment may be the same as the conductive structure 200 described in FIG. 4A, except another surface of the conductive material layer 210 may be connected to a second work function control layer 225. The second work function control layer 225 may include same two-dimensional material layer with a defect as the work function control layer 220 in FIG. 4A, or the work function control layer 220 and second work function control layer 225 may include different two-dimensional material layers with a defect. Although not illustrated, a metal carbide may be between the conductive material layer 210 and the second work function control layer 225.

In example embodiments, a method of controlling a work function of a metal may include preparing a conductive structure that includes a conductive material layer having metal and having a first work function, and then bonding a first work function control layer to the conductive material layer to adjust a work function of the conductive structure to a second work function that is lower than the first work function. The first work function control layer may include a first two-dimensional material with a defect (e.g., nanocrystalline graphene). Then, the method may further include removing the first work function control layer to adjust the work function of the conductive structure to a third work function that may be greater than the second work function. The third work function may be about equal to the first work function, but is not limited thereto. Then, the method may further include bonding a second work function control layer to the conductive material layer to adjust the work function of the conductive structure to a fourth work function that is lower than the third work function. The fourth work function may be the same as or different than the second work function. The fourth work function may be lower than the third work function. The second work function control layer may include a second two-dimensional material with a defect (e.g. nanocrystalline h-BN) that may be different than a material of the first two-dimensional material with a defect (e.g., nanocrystalline graphene). The first two-dimensional material and the second two-dimensional material independently may be single layer or multi-layer. The second work function control layer may be removed to adjust a work function of the conductive structure from a fourth work function to a fifth work function. The fifth work function may be greater than the fourth work function and the fifth work function may be equal to the first work function and/or the third work function.

In example embodiments, a method of controlling a work function of a metal may be applied to a method of manufacturing a conductive structure. The method of manufacturing a conductive structure may include bonding a work function control layer to a conductive material layer including metal, where the work function control layer may include a two-dimensional material with a defect. The method of manufacturing a conductive structure may be applied to a method of manufacturing a device including the conductive structure by preparing a substrate, manufacturing the conductive structure on the substrate by bonding a work function control layer to a conductive material layer including metal, where the work function control layer may include a two-dimensional material with a defect, and then forming another layer (e.g., insulating layer, semiconductor layer, and/or conductive layer) to the conductive structure.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of inventive concepts as defined by the following claims.

## Claims

1. A conductive structure comprising:
a conductive material layer including metal; and
a work function control layer bonded to the conductive material layer, the work function control layer including a two-dimensional material with a defect, and the work function control layer being configured to control a work function of the conductive structure by being bonded to the conductive material layer.

2. The conductive structure of claim 1, wherein the work function control layer is configured to make the work function of the conductive structure lower than a work function of the conductive material layer.

3. The conductive structure of claim 1 or 2, wherein the two-dimensional material with the defect has a two-dimensional crystalline structure and a grain size of 100 nm or less, and optionally wherein the two-dimensional material with the defect has a thickness of several nanometers.

4. The conductive structure of claim 3, wherein the two-dimensional material with the defect comprises nanocrystalline graphene, and optionally further comprising:
metal carbide between the conductive material layer and the work function control layer.

5. The conductive structure of claim 3, wherein the two-dimensional material with a defect comprises nanocrystalline h-boron nitride (h-BN).

6. The conductive structure of claim 3, wherein the two-dimensional material with a defect comprises a nanocrystalline transition metal dichalcogenide (TMD) compound or nanocrystalline black phosphorous (BP).

7. The conductive structure of any preceding claim, wherein the two-dimensional material with a defect has a single layer structure.

8. The conductive structure of any of claims 1 to 6, wherein the two-dimensional material with a defect has a multilayer structure.

9. The conductive structure of any preceding claim, wherein the work function control layer is bonded to the conductive material layer by deposition or transfer.

10. A method of controlling a work function of metal, the method comprising:
controlling the work function by bonding a work function control layer to a conductive material layer including metal,
the work function control layer including a two-dimensional material with a defect.

11. The method of claim 10, wherein
the work function control layer is configured to control a work function of a conductive structure including the conductive material layer, and
the work function control layer is configured to make the work function of the conductive structure lower than a work function of conductive material layer.

12. The method of claim 10 or 11, wherein the two-dimensional material with the defect has a two-dimensional crystalline structure and a grain size of 100 nm or less, and optionally wherein the two-dimensional material with the defect has a thickness of several nanometers.

13. The method of claim 12, wherein the two-dimensional material with the defect comprises nanocrystalline graphene.

14. The method of claim 12, wherein the two-dimensional material with the defect comprises nanocrystalline h-BN, nanocrystalline transition metal dichalcogenide compound, or nanocrystalline black phosphorous.

15. The method of any of claims 10 to 12, wherein the two-dimensional material with the defect has a single layer structure or a multilayer structure.
